# FASCICULE DE BREVET EUROPEEN

(11) **EP 3 971 995 B1**
(45) Date de publication et mention de la délivrance du brevet: **12.07.2023**
(21) Numéro de dépôt: 21197570.1
(22) Date de dépôt: 17.09.2021
(51) Int. Cl.: H01L 31/105

(54) **PHOTODIODE PASSIVÉE COMPORTANT UNE PORTION PÉRIPHÉRIQUE FERROÉLECTRIQUE**
PASSIVIERTE FOTODIODE MIT EINEM FERROELEKTRISCHEN PERIPHEREN TEIL
PASSIVATED PHOTODIODE COMPRISING A PERIPHERAL FERROELECTRIC PORTION

(30) Priorité: 21.09.2020 FR 2009529
(43) Date de publication de la demande: 23.03.2022
(73) Titulaire: Commissariat à l'énergie atomique et aux énergies alternatives, 75015 Paris (FR)
(72) Inventeur: ALIANE, Abdelkader, 38054 GRENOBLE (FR); KAYA, Hacile, 38054 GRENOBLE (FR)
(74) Mandataire: INNOV-GROUP

(56) Documents cités:
- FR-A1- 3 089 348
- US-A1- 2020 052 146

## Description

### DOMAINE TECHNIQUE

Le domaine de l'invention est celui des photodiodes passivées par une couche diélectrique de passivation. L'invention trouve une application notamment dans le domaine de la détection d'un rayonnement lumineux appartenant par exemple au proche infrarouge, la ou les photodiodes pouvant alors être réalisées à base de germanium.

### ÉTAT DE LA TECHNIQUE ANTÉRIEURE

Les dispositifs optoélectroniques de photodétection peuvent comporter une matrice de photodiodes passivées. Les photodiodes s'étendent alors suivant un même plan principal, entre des première et deuxième surfaces opposées et parallèles entre elles. Elles comportent alors chacune une première région dopée par exemple de type n et affleurant la première surface, et une deuxième région dopée par exemple de type p et affleurant la deuxième surface. Les deux régions dopées sont alors séparées l'une de l'autre par une région intermédiaire intrinsèque ou très peu dopée par exemple de type p. Une couche de passivation réalisée en un matériau diélectrique recouvre 1a première surface dans le but de limiter la contribution du courant d'obscurité au courant électrique mesuré par chaque photodiode.

Cependant, il apparaît que la présence de la couche diélectrique de passivation peut malgré tout contribuer à générer un courant d'obscurité non négligeable. Ainsi, l'article de Sood et al. intitulé Characterization of SiGe-Detector Arrays for Visible-NIR Imaging Sensor Applications, Proc. of SPIE VOL. 8012, 801240, 2011, décrit un procédé de fabrication d'une photodiode passivée permettant de limiter le courant d'obscurité. Le courant d'obscurité est lié à la présence d'une zone déplétée située dans le matériau semiconducteur de la photodiode, à l'interface avec la couche diélectrique de passivation. Le procédé de fabrication comporte alors une étape de recuit sous N₂H₂ de la photodiode, permettant de transformer cette zone déplétée en une zone d'accumulation de trous. Cette étape permet alors de réduire l'intensité du courant d'obscurité.

Or, il apparaît que cette étape de recuit, destinée à modifier la zone déplétée en une zone d'accumulation, peut induire une dégradation des performances de la photodiode, notamment du fait d'une modification non souhaitée des dimensions de la première région dopée n, en particulier lorsque la diffusion latérale des éléments dopants de type n est importante. Par ailleurs, la présence et les caractéristiques de la zone déplétée peuvent être liées à la technique utilisée de dépôt de la couche diélectrique de passivation ainsi qu'aux conditions opératoires. Il en résulte que le recuit en question peut alors ne pas permettre d'obtenir de manière reproductible la zone d'accumulation souhaitée et donc la réduction voulue du courant d'obscurité.

Par ailleurs, le document EP3657556A1 décrit un exemple de photodiode passivée réalisée à base de germanium comportant un région périphérique dopée p entourant le caisson dopé n+ et affleurant la face de germanium recouverte par la couche diélectrique de passivation. Cette région périphérique permet notamment de réduire le courant d'obscurité en limitant la composante de surface du courant d'obscurité.

On connaît également le document EP3660930A1 qui décrit un autre exemple de photodiode passivée réalisée à base de germanium. La couche de passivation n'est pas réalisée en un matériau diélectrique mais est réalisée à base de silicium. Un recuit est effectué pour provoquer une interdiffusion du silicium de la couche de passivation et du germanium de la couche de détection. Ainsi, le caisson dopé n+ est entouré par une zone périphérique à base de SiGe qui forme une « ouverture de gap » permettant de limiter la composante de surface du courant d'obscurité.

Il existe cependant un besoin de disposer d'une autre solution permettant de réduire le courant d'obscurité dans une photodiode passivée et notamment sa composante de surface.

### EXPOSÉ DE L'INVENTION

L'invention a pour objectif de remédier au moins en partie aux inconvénients de l'art antérieur, et plus particulièrement de proposer une photodiode passivée permettant d'obtenir un faible courant d'obscurité, et notamment de sa composante de surface.

Pour cela, l'objet de l'invention est une photodiode présentant une première surface (10a) et une deuxième surface opposées l'une à l'autre et parallèles à un plan principal, comportant :
- une portion de détection, réalisée en un matériau semiconducteur, comportant :
   o une première région dopée selon un premier type de conductivité et affleurant la première surface, et destinée à être polarisée électriquement ;
   o une deuxième région dopée selon un deuxième type de conductivité opposé au premier type, et affleurant la deuxième surface ;
   o une région intermédiaire, située entre la première région et la deuxième région ;
- une couche diélectrique, recouvrant la portion de détection sur la première surface en venant au contact de la première région ;
- une portion périphérique semiconductrice, réalisée en un matériau semiconducteur dopé selon le deuxième type de conductivité, destinée à être polarisée électriquement, et entourant la portion de détection dans le plan principal et venant au contact de la deuxième région.

Selon l'invention, la photodiode comporte en outre une portion périphérique ferroélectrique, réalisée en un matériau ferroélectrique, située entre et au contact de la région intermédiaire et de la couche diélectrique, et située entre la première région et la portion périphérique semiconductrice et entourant la première région dans le plan principal.

Certains aspects préférés mais non limitatifs de cette photodiode sont les suivants.

La portion périphérique ferroélectrique peut être latéralement au contact de la première région d'une part, et de la portion périphérique semiconductrice d'autre part.

La portion de détection peut présenter une échancrure périphérique délimitant une partie en saillie entourée par la portion périphérique ferroélectrique dans le plan principal.

La portion de détection peut être réalisée à base de germanium, et la portion périphérique semiconductrice peut être réalisée à base de silicium.

La portion périphérique ferroélectrique peut être réalisée à base d'un matériau choisi parmi le PZT, le PLZT, le BT, le PT, le PLT, le PVDF, ainsi que parmi le HfO₂, le ZnO, et le AlN.

La couche diélectrique peut être traversée par une métallisation centrale venant contacter la première région, et par une métallisation latérale venant contacter la portion périphérique semiconductrice.

La photodiode peut comporter une électrode périphérique s'étendant sur la couche diélectrique et au contact de la métallisation latérale, entourant la première région, et située à la verticale de la portion périphérique ferroélectrique.

L'invention porte également sur une matrice de photodiodes, comportant une pluralité de photodiodes selon l'une quelconque des caractéristiques précédentes, dans laquelle des faces supérieures des premières régions opposées aux deuxièmes régions sont coplanaires, et les deuxièmes surfaces sont coplanaires.

L'invention porte également sur un dispositif optoélectronique comportant une matrice de photodiodes selon l'une quelconque des caractéristiques précédentes, et une puce de commande hybridée à la matrice de photodiodes, adaptée à polariser en inverse les photodiodes.

L'invention porte également sur un procédé de fabrication d'une photodiode selon l'une quelconque des caractéristiques précédentes, comportant les étapes suivantes :
- réalisation d'un empilement comportant une première sous-couche dopée sur le deuxième type de conductivité et destinée à former la deuxième région, recouverte d'une deuxième sous-couche destinée à former la région intermédiaire ;
- dépôt d'une couche isolante supérieure sur la deuxième sous-couche ;
- réalisation de la portion périphérique semiconductrice s'étendant au travers de la couche isolante supérieure et de la deuxième sous-couche, jusqu'à déboucher sur la première sous-couche ;
- réalisation d'une échancrure périphérique dans la deuxième sous-couche, au travers d'une ouverture périphérique entourant une portion centrale de la couche isolante supérieure ;
- réalisation de la portion périphérique ferroélectrique remplissant l'échancrure périphérique ;
- suppression de la portion centrale ;
- réalisation de la première région dans la deuxième sous-couche ;
- dépôt de la couche diélectrique sur et au contact de la portion périphérique ferroélectrique et de la première région.

Le procédé peut comporter une étape de recuit de cristallisation du matériau de la portion périphérique ferroélectrique, assurant en outre une diffusion des éléments dopants depuis la portion périphérique semiconductrice dans la portion de diffusion, formant ainsi dans la portion de détection une région latérale dopée selon le deuxième type de conductivité.

La portion de détection peut être réalisée à base de germanium et portion périphérique semiconductrice être réalisée à base de silicium. Le recuit de cristallisation peut assurer en outre une diffusion du silicium de la portion périphérique semiconductrice vers la portion de détection, formant ainsi une zone latérale réalisée à base de silicium germanium.

L'étape de réalisation de la première région peut comporter l'implantation d'éléments dopants dans la deuxième sous-couche au travers de la portion centrale.

La profondeur d'implantation peut être inférieure à l'épaisseur de la portion périphérique ferroélectrique étant au contact, latéralement, d'une partie en saillie de la deuxième sous-couche délimitée par l'échancrure périphérique. Le procédé peut comporter un recuit d'activation des éléments dopants, la portion périphérique ferroélectrique assurant un blocage latéral de la diffusion desdits éléments dopants lors de ce recuit.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1A est une vue schématique et partielle, en coupe transversale, d'une photodiode selon un mode de réalisation, comportant une portion périphérique ferroélectrique dont les dipôles ferroélectriques sont orientés horizontalement lors de la polarisation de la photodiode ;
la figure 1B est une vue schématique et partielle, en coupe transversale, d'une photodiode selon une variante de réalisation, comportant une portion périphérique ferroélectrique dont les dipôles ferroélectriques sont orientés verticalement lors de la polarisation de la photodiode ;
les figures 2A à 2O illustrent différentes étapes d'un procédé de réalisation d'une photodiode selon le mode de réalisation illustré sur la fig. 1A ;
les figures 3A à 3C illustrent différentes étapes d'un procédé de réalisation d'une photodiode selon le mode de réalisation illustré sur la fig.1B.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur une photodiode passivée, et de préférence sur une matrice de photodiodes, ainsi que sur le procédé de fabrication. Chaque photodiode est de préférence réalisée à base de germanium et est adaptée à détecter un rayonnement lumineux dans le proche infrarouge (SWIR, pour *Short Wavelength IR*, en anglais) correspondant à la gamme spectrale allant de 0,8µm à 1,7µm environ, voire à 2,5µm environ.

Les photodiodes présentent une première surface et une deuxième surface opposées l'une à l'autre et parallèles à un plan principal de la photodiode. Ces première et deuxième surfaces, dites de référence, peuvent être planaires, et sont communes d'une photodiode à l'autre. Les photodiodes comportent chacune une portion semiconductrice dite de détection, au sein de laquelle est présente une jonction PN ou PIN, délimitée verticalement (suivant l'axe de l'épaisseur) entre les première et deuxième surfaces de référence. Chaque photodiode comporte une première région dopée selon un premier type de conductivité, par exemple de type n, affleurant la première surface et formant un caisson dopé, une deuxième région dopée selon un deuxième type de conductivité, par exemple de type p, affleurant la deuxième surface, et une région intermédiaire située entre les deux régions dopées et entourant la première région dopée dans le plan principal. Cette région intermédiaire peut être dopée selon le deuxième type de conductivité, par exemple de type p, pour former une jonction PN, ou être intrinsèque, c'est-à-dire non intentionnellement dopée, pour former une jonction PIN.

Les photodiodes ne présentent pas une structure en mesa, dans la mesure où elles sont isolées optiquement les unes des autres par des tranchées périphériques remplies par un matériau semiconducteur dopé. Par ailleurs, la photodiode est dite passivée dans la mesure où une surface de la portion semiconductrice de détection est en partie recouverte par une portion ferroélectrique, disposée entre cette portion semiconductrice de détection et une couche diélectrique, permettant de réduire la composante de surface du courant d'obscurité de la photodiode.

D'une manière générale, le courant d'obscurité d'une photodiode est le courant électrique présent au sein de la photodiode en fonctionnement, lorsqu'elle n'est pas soumise à un rayonnement lumineux. Il peut être formé de courants générés thermiquement à l'intérieur du volume de la portion semiconductrice de détection (courants de diffusion, courants de déplétion, courants tunnel...) et de courants de surface. Les courants de surface peuvent être liés à la présence de charges électriques dans la couche diélectrique de passivation mentionnée dans l'article de Sood et al. 2011. En effet, ces charges électriques peuvent induire une modification de la courbure des bandes d'énergie à proximité de la surface, conduisant à la formation d'une zone déplétée voire d'une zone d'inversion dans la portion de détection. La zone déplétée, lorsqu'elle est située dans la zone de charge d'espace de la photodiode, peut donner lieu à des courants parasites de type génération-recombinaison. Par ailleurs, la zone d'inversion, alors électriquement conductrice, peut permettre le déplacement de charges électriques entre des régions polarisées dopées n et p et situées à l'interface avec la couche diélectrique de passivation.

Aussi, la ou les photodiodes selon l'invention comportent, pour chaque photodiode, une portion périphérique réalisée en un matériau ferroélectrique, située entre et au contact de la région intermédiaire et de la couche diélectrique suivant un axe orthogonal au plan principal de la photodiode, et entourant la première région dans le plan principal. Ainsi, comme expliqué plus loin, on réduit la composante de surface du courant d'obscurité, ce qui permet d'améliorer les performances de la ou des photodiodes. En effet, cette portion périphérique ferroélectrique, par l'orientation suivant une direction privilégiée des dipôles ferroélectriques lors de la polarisation de la photodiode, permet de limiter ou d'éviter la formation d'une zone déplétée ou d'une zone d'inversion dans la portion de détection, et permet d'éviter la circulation de porteurs de charge dans cette même portion périphérique ferroélectrique, entre la première région dopée et la région périphérique semiconductrice dopée.

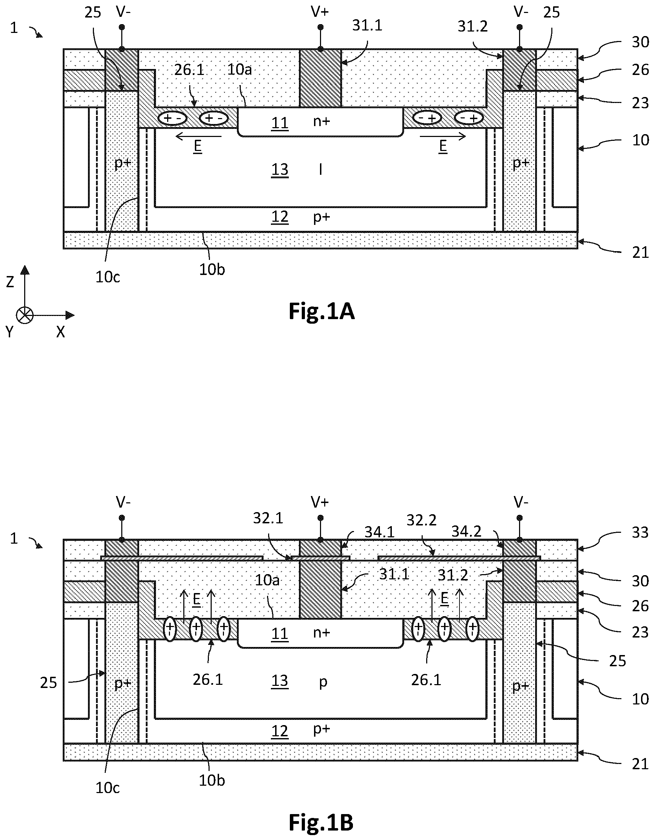

La figure 1A est une vue partielle et schématique, en coupe transversale, d'une photodiode 1 passivée appartenant à une matrice de photodiodes, selon un mode de réalisation. Dans cet exemple, les photodiodes 1 sont réalisées à base de germanium. Elles sont polarisées en inverse à partir du côté de la première surface 10a, et sont optiquement isolées les unes des autres par des tranchées remplies d'un matériau semiconducteur dopé.

On définit ici et pour la suite de la description un repère direct tridimensionnel XYZ, où les axes X et Y forment un plan parallèle au plan principal des photodiodes, et où l'axe Z est orienté suivant l'épaisseur de la portion de détection 10 de la photodiode 1, à partir de la deuxième surface 10b en direction de la première surface 10a. Les termes « inférieur » et « supérieur » font référence à un positionnement croissant suivant la direction +Z.

La photodiode 1 comporte une portion de détection 10 s'étendant suivant l'axe Z entre une première et une deuxième surfaces de référence, 10a et 10b, parallèles entre elles et opposées l'une à l'autre. Les première et deuxième surfaces 10a, 10b sont communes à chaque photodiode 1 de la matrice. Comme décrit plus loin, la première surface 10a est définie par la face supérieure de la première région 11 dopée n+ et par une partie de la face supérieure de la portion périphérique ferroélectrique 26. L'épaisseur maximale de la portion de détection 10, définie suivant l'axe Z entre les première et deuxième surfaces 10a, 10b, est ici sensiblement constante d'une photodiode à l'autre, par exemple est comprise entre quelques centaines de nanomètres et quelques microns, par exemple entre 1µm et 5µm environ. L'épaisseur est choisie de manière à obtenir une bonne absorption dans la gamme de longueurs d'onde du rayonnement lumineux à détecter. La portion de détection 10 présente une dimension transversale dans le plan XY pouvant être comprise entre quelques centaines de nanomètres et quelques dizaines de microns, par exemple comprise entre 1µm et 20µm environ.

La portion de détection 10 est réalisée en au moins un matériau semiconducteur cristallin, de préférence monocristallin. Elle est par ailleurs réalisée à base d'un élément chimique d'intérêt, ici à base de germanium. Par à base de, on entend que le matériau semiconducteur cristallin correspond à l'élément chimique d'intérêt ou est un alliage formé d'au moins l'élément chimique d'intérêt. L'élément chimique d'intérêt est avantageusement du germanium, de sorte que les photodiodes sont réalisées en germanium Ge, en silicium germanium SiGe, le germanium étain GeSn, et le silicium germanium étain SiGeSn. Dans cet exemple, la portion de détection 10 est issue d'au moins une couche réalisée en le même élément chimique d'intérêt, à savoir ici en germanium. Elle peut ainsi être une couche ou un substrat réalisé en le même matériau semiconducteur et présenter des régions de différents types de conductivité (homojonction) de manière à former une jonction PN ou PIN. Elle peut en variante être un empilement de sous-couches de différents matériaux semiconducteurs (hétérojonction), lesquels sont alors formés à base de l'élément chimique d'intérêt.

La portion de détection 10 est ainsi formée d'une première région 11 dopée selon un premier type de conductivité, ici de type n, qui affleure la première surface 10a et forme un caisson dopé n+, et une deuxième région 12 dopée selon un deuxième type de conductivité, ici de type p, qui affleure la deuxième surface 10b. Par affleurer, on entend « arriver au niveau de », ou « s'étend à partir de ». Une région intermédiaire 13 intrinsèque (dans le cas d'une jonction PIN), ou dopée selon le deuxième type de conductivité (dans le cas d'une jonction PN), est située entre et au contact des deux régions dopées 11 et 12, et entoure la première région 11 dopée n dans le plan principal. Dans cet exemple, la jonction semiconductrice est de type PIN, la première région 11 étant dopée de type n+, la deuxième région 12 dopée de type p+ et la région intermédiaire 13 est intrinsèque (non intentionnellement dopée).

La première région 11 dopée n+ s'étend ici à partir de la première surface 10a et est entourée par une portion périphérique ferroélectrique 26.1 dans le plan principal, et éventuellement par la région intermédiaire 13. Elle est distante de la bordure latérale 10c de la portion de détection 10 dans le plan XY, la bordure latérale 10e étant définie par la face interne d'une portion périphérique semiconductrice 25 dopée p+. Elle forme ainsi un caisson dopé n+ qui affleure la première surface 10a et est espacée d'une distance non nulle vis-à-vis de la bordure latérale 10c ainsi que de la deuxième surface 10b. La première région 11 dopée n+ participe ainsi à délimiter la première surface 10a. Elle peut présenter un dopage pouvant être compris entre 10¹⁹ et 10²¹ at/cm³ environ.

La deuxième région 12 dopée ici p+ s'étend dans le plan XY en affleurant la deuxième surface 10b, ici à partir de la bordure latérale 10c. Elle s'étend suivant l'axe Z à partir de la deuxième surface 10b. Elle peut présenter une épaisseur sensiblement homogène suivant l'axe Z et ainsi affleurer uniquement une zone inférieure de la bordure latérale 10c. En variante, comme illustré sur les fig. 1A et 1B, la deuxième région 12 dopée p+ peut présenter une région latérale 14 dopée p+ qui affleure continûment la bordure latérale 10c suivant l'axe Z et s'étend sur toute la périphérie de la portion de détection 10. La deuxième région 12 dopée p+ peut présenter un dopage pouvant être compris entre 10¹⁸ et 10²⁰ at/cm³ environ.

La région intermédiaire 13 est située entre les deux régions 11, 12 dopées n+ et p+. Elle peut entourer la première région 11 dopée n+ dans le plan XY, et est séparée de la première surface 10a et donc de la couche diélectrique 30 par la portion périphérique ferroélectrique 26.1. Elle est ici réalisée en un matériau semiconducteur intrinsèque de manière à former une jonction PIN mais peut être dopée selon le deuxième type de conductivité, par exemple de type p, pour former une jonction PN (cf. fig. 1B).

La photodiode 1 comporte ici une couche isolante inférieure 21, réalisée en un matériau diélectrique, recouvrant la deuxième surface 10b de la portion de détection 10, ainsi que, comme décrit plus loin, la face inférieure de la portion périphérique semiconductrice 25 dopée p+. La couche isolante inférieure 21 peut en outre être adaptée à former une fonction d'antireflet vis-à-vis du rayonnement lumineux incident. Elle forme en effet la face de réception du rayonnement lumineux destiné à être détecté.

La portion de détection 10 de la photodiode 1 est ici délimitée latéralement, dans le plan XY, par une tranchée, de préférence continue, remplie d'un matériau semiconducteur dopé selon le deuxième type de conductivité (ici de type p), et formant une portion périphérique semiconductrice 25, ici dopée p+. La portion traversante périphérique 25 participe à polariser électriquement la photodiode 1, ici à partir du côté de la première surface 10a, et à pixelliser la matrice de photodiodes (isolation optique). Elle s'étend ici sur toute l'épaisseur de la portion de détection 10 pour déboucher sur la couche isolante inférieure 21, mais en variante, elle peut ne pas déboucher sur la couche isolante inférieure 21 et peut se terminer dans la deuxième région 12 dopée p+. La face interne de cette portion périphérique semiconductrice 25 dopée p+ définit alors la bordure latérale 10c de la portion de détection 10. Le matériau semiconducteur est de préférence réalisé à base de silicium, par exemple du silicium amorphe, du silicium polycristallin, du silicium germanium, voire peut être réalisé en germanium amorphe.

La couche diélectrique 30 recouvre la première surface 10a de la photodiode 1, et permet d'isoler électriquement les contacts 31.1 et 31.2. Elle est ainsi au contact de la première région 11 dopée n+ ainsi que de la portion périphérique ferroélectrique 26.1. Elle est réalisée en un matériau diélectrique, tel qu'un oxyde de silicium, un nitrure de silicium, ou un oxynitrure de silicium. D'autres matériaux diélectriques peuvent être utilisés, tels qu'un oxyde d'hafnium ou d'aluminium, voire un nitrure d'aluminium, entre autres. Elle présente une épaisseur par exemple comprise entre 50nm et 500nm.

Cependant, il apparaît que la technique de dépôt de passivation utilisée peut participer à générer une contribution surfacique du courant d'obscurité lorsqu'elle repose sur et au contact de la région intermédiaire 13. En effet, comme l'indique l'article de Sood et al. 2011 mentionné précédemment, la couche diélectrique peut induire la formation d'une zone déplétée dans la région intermédiaire 13 à partir de la première surface 10a. Lorsque cette zone déplétée est située dans la zone de charge d'espace de la photodiode 1, elle peut alors être le lieu d'un courant parasite de génération-recombinaison. Par ailleurs, une telle couche diélectrique peut former une zone d'inversion, alors électriquement conductrice, qui peut donc connecter la première région 11 dopée n+ à la portion périphérique semiconductrice dopée p+.

Aussi, chaque photodiode 1 comporte une portion périphérique 26.1 réalisée en un matériau ferroélectrique, située entre et au contact de la région intermédiaire 13 et la couche diélectrique 30, et située entre la première région 11 dopée n+ et la portion périphérique semiconductrice 25 en entourant la première région 11 dopée n+ dans le plan XY. La portion périphérique ferroélectrique 26.1 est ainsi au contact de la couche diélectrique 30 en une face supérieure, et au contact de la région intermédiaire 13 en sa face inférieure.

Par entourer, on entend que la région périphérique ferroélectrique 26.1 s'étend autour de la première région 11 dopée n+ dans le plan principal, de manière continue ou éventuellement discontinue. La région périphérique ferroélectrique 26.1 s'étend ainsi suivant l'axe Z à partir de la première surface 10a, et entoure dans le plan XY la première région 11 dopée n+. Elle est située ici au contact de la première région 11 dopée n+ (espacement nul), notamment lorsque l'élément dopant de la première région 11 dopée n+ est du phosphore, qui a tendance à diffuser rapidement, mais en variante peut ne pas être au contact de celle-ci (espacement non nul). Elle est également située au contact de la portion périphérique semiconductrice dopée p+ (espacement nul), mais en variante peut ne pas être au contact de celle-ci (espacement non nul).

Un matériau ferroélectrique présente une polarisation électrique (ou moment dipolaire électrique) spontanée qui peut être orientée par l'application d'un champ électrique extérieur, ici par le champ électrique généré entre la première région 11 dopée n+ et la région périphérique semiconductrice 25 dopée p+ lorsque la photodiode est polarisée (en inverse). La région périphérique ferroélectrique 26.1 peut être réalisée en un matériau choisi parmi les oxydes de structure perovskite, comme par exemple le PZT Pb(Zr,Ti)O₃, le PLZT (Pb,La)(Zr,Ti)O₃, le BT BaTiO₃, le PT PbTiO₃, le PLT (Pb,La)TiO₃, le poly(fluorure de vinylidène) (PVDF), ainsi que parmi le HfO₃, le ZnO, le AlN, entre autres, et leurs mélanges. Le matériau ferroélectrique est de préférence choisi parmi le PZT, le BT, le PVDF, le HfO₂, le ZnO, le AlN, pour des raisons notamment de facilité d'utilisation dans le procédé de fabrication d'une telle photodiode.

Ainsi, la polarisation de la photodiode 1 permet d'orienter les dipôles ferroélectriques présents dans la région périphérique ferroélectrique 26.1 suivant une direction privilégiée, par exemple une direction radiale dans le plan XY ou une direction verticale suivant l'axe Z. Aussi, par le fait que cette région périphérique ferroélectrique 26.1 soit située entre et au contact de la couche diélectrique 30 et de la région intermédiaire 13 d'une part, et entoure la première région 11 dopée n+ dans le plan XY d'autre part, permet d'éviter la présence d'une zone déplétée voire d'une zone d'inversion dans la région intermédiaire 13 sous la première surface 10a. De plus, l'orientation des dipôles ferroélectriques dans cette région périphérique ferroélectrique 26.1 permet de bloquer le passage des porteurs de charge entre la première région 11 dopée n+ et la portion périphérique semiconductrice 25 dopée p+ sous la couche diélectrique 30, dans cette même région périphérique ferroélectrique 26.1. Elle assure donc une fonction d'isolation électrique latérale entre la première région 11 dopée n+ et la portion périphérique semiconductrice 25 dopée p+ au niveau de la première surface 10a, réduisant ainsi les risques de court-circuit entre ces parties de la photodiode 1 du fait par exemple de la zone d'inversion. On réduit ainsi les composantes de surface du courant d'obscurité, ce qui permet d'améliorer les performances de la photodiode.

En outre, la présence de cette région périphérique ferroélectrique 26.1 autorise la réduction de l'espacement latéral entre la première région 11 dopée n+ et la portion périphérique semiconductrice 25 dopée p+, améliorant ainsi les performances de la photodiode 1. On évite ainsi la situation où, en l'absence d'une telle région périphérique ferroélectrique 26.1, les porteurs photogénérés dans la région intermédiaire 13 à proximité de la première surface 10a ne soient pas collectés du fait d'une qualité insuffisante de la passivation de cette première surface 10a.

Par ailleurs, la portion de détection 10 comporte avantageusement une région latérale 14 dopée selon le deuxième type de conductivité, ici de type p+, située au niveau de la bordure latérale 10c. Cette région latérale 14 présente un niveau de dopage supérieur à celui de la région intermédiaire 13 lorsqu'elle est dopée. La région latérale 14 dopée p+ affleure la bordure latérale 10c et est au contact de la portion périphérique semiconductrice 25 dopée p+. Ainsi, la polarisation de la deuxième région 12 dopée p+ est améliorée dans la mesure où la surface de contact avec la portion périphérique semiconductrice 25 dopée p+ est augmentée. De plus, cette région latérale 14 dopée p+ permet d'éviter que la zone de charge d'espace de la photodiode 1 ne s'étende jusqu'à la bordure latérale 10c. Ainsi, on limite la contribution de cette zone (potentiellement non exempte de défauts liés à la réalisation des tranchées) au courant d'obscurité. On améliore ainsi les performances de la photodiode 1.

Par ailleurs, la portion de détection 10 est réalisée à base de germanium, par exemple en germanium, et la portion périphérique semiconductrice 25 dopée p+ est réalisée à base de silicium, par exemple en silicium polycristallin dopé. La portion de détection 10 comporte alors avantageusement une zone latérale 15 réalisée à base de silicium germanium. La zone latérale 15 affleure la bordure latérale 10c et est au contact de la portion périphérique semiconductrice 25 dopée p+. Ainsi, la zone latérale 15 présente une énergie de bande interdite (gap) supérieure à celle de la portion de détection 10 réalisée en germanium. Cette « ouverture de gap » latérale permet de diminuer la sensibilité de la photodiode 1 aux défauts présents à proximité des tranchées. On améliore ainsi également les performances de la photodiode 1.

La photodiode 1 comporte en outre un circuit électrique permettant de la polariser en inverse. Dans cet exemple, le circuit électrique permet de polariser la photodiode 1 à partir du côté de la première surface 10a. Le circuit électrique peut comporter des métallisations de contact 31.1, 31.2 s'étendant au travers d'ouvertures traversantes de la couche diélectrique 30 et venant au contact respectivement de la première région 11 dopée n+ et de la portion périphérique semiconductrice 25 dopée p+. La photodiode 1 est destinée à être polarisée en inverse, par exemple en appliquant un potentiel électrique négatif à la portion périphérique semiconductrice 25 dopée p+ et en portant la première région 11 dopée n+ à la masse.

A ce titre, la fig. 1A illustre une première configuration de blocage électrique dit latéral, dans laquelle les dipôles ferroélectriques sont orientés, lorsque la photodiode est polarisée en inverse, de manière sensiblement parallèle au plan XY, suivant une direction radiale allant de la première région 11 dopée n+ vers la portion périphérique semiconductrice 25 dopée p+. En effet, la polarisation en inverse de la photodiode génère un champ électrique E entre la première région 11 dopée n+ et la portion périphérique semiconductrice 25 dopée p+, qui oriente les dipôles ferroélectriques suivant ladite direction radiale dans le plan XY. Ainsi, cette configuration permet notamment de bloquer le passage des porteurs de charge au niveau de la première surface 10a, dans la portion périphérique ferroélectrique 26.1, réduisant ainsi la composante de surface du courant d'obscurité.

L'espacement radial, dans le plan XY, entre la première région 11 dopée n+ et la portion périphérique semiconductrice 25 dopée p+ peut être compris entre 100nm et 2µm environ. Une valeur comprise entre 100nm et 200nm environ permet d'assurer un blocage électrique latéral efficace tout en maximisant le taux de remplissage (dans le cas d'une matrice de photodiodes). Le taux de remplissage est défini comme le rapport de la surface dans le plan XY de la portion de détection 10 sur la surface dans le plan XY de la photodiode 1 (délimitée ici par la face externe de la portion périphérique semiconductrice 25 dopée p+).

La figure 1B est une vue schématique et partielle d'une photodiode selon une variante du mode de réalisation illustré sur la fig. 1A, illustrant une deuxième configuration de blocage électrique, ici dit vertical. Dans cette configuration, lorsque la photodiode est polarisée en inverse, les dipôles ferroélectriques sont orientés verticalement, c'est-à-dire suivant l'axe Z. Pour cela, la photodiode 1 comporte au moins une électrode planaire périphérique 32.2, disposée au contact d'une métallisation de contact périphérique 31.2, et s'étendant dans un plan XY en regard, c'est-à-dire à la verticale, de la portion périphérique ferroélectrique 26.1, et éventuellement en regard d'au moins une partie de la première portion 11 dopée n+. La métallisation de contact périphérique 31.2 est celle qui vient contacter la portion périphérique semiconductrice 25 dopée p+.

Ainsi, la polarisation en inverse de la photodiode 1, par exemple en appliquant un potentiel électrique négatif à la portion périphérique semiconductrice 25 dopée p+ et en portant la première portion 11 dopée n+ à la masse, génère un champ électrique E entre la première région 11 dopée n+ d'une part, et d'autre part l'électrode planaire périphérique 32.2 et la deuxième région 12 dopée p+ d'autre part, qui oriente les dipôles ferroélectriques suivant l'axe Z. En effet, la composante verticale (suivant l'axe Z) du champ électrique E au niveau de la portion périphérique ferroélectrique 26.1 prédomine sur la composante horizontale (dans le plan XY) du fait de la surface importante de l'électrode planaire périphérique 32.2 qui est en regard de la portion périphérique ferroélectrique 26.1 (et éventuellement d'une partie de la première portion 11 dopée n+). Ainsi, cette configuration permet de réduire le risque de formation d'une zone de déplétion voire d'une zone d'inversion sous la couche diélectrique 30 dans la région intermédiaire 13, réduisant ainsi la composante de surface du courant d'obscurité. De plus, l'électrode planaire périphérique 32.2 permet de réfléchir le rayonnement électromagnétique de détection initialement non absorbé, et permet donc d'augmenter la sensibilité de la photodiode.

D'une manière générale, à titre illustratif, la photodiode 1 peut présenter des dimensions dans le plan XY comprises entre 1µm et 100µm environ. L'épaisseur de la deuxième région 12 dopée p+ peut être comprise entre 20nm et 500nm environ. L'épaisseur de la région intrinsèque 13 peut être comprise entre 0.7µm et 2.5µm environ lorsque la photodiode 1 est destinée à détecter un rayonnement lumineux dans la gamme du SWIR ou du proche infrarouge (NIR). La première région 11 dopée n+ peut présenter une épaisseur comprise entre 10nm et 600nm environ. La couche diélectrique 30 peut présenter une épaisseur permettant de recouvrir entièrement la face supérieure de la photodiode 1 et par exemple comprise entre 10nm et 600nm environ, et l'épaisseur de la couche isolante inférieure 21 peut être comprise entre 50nm et 1µm environ.

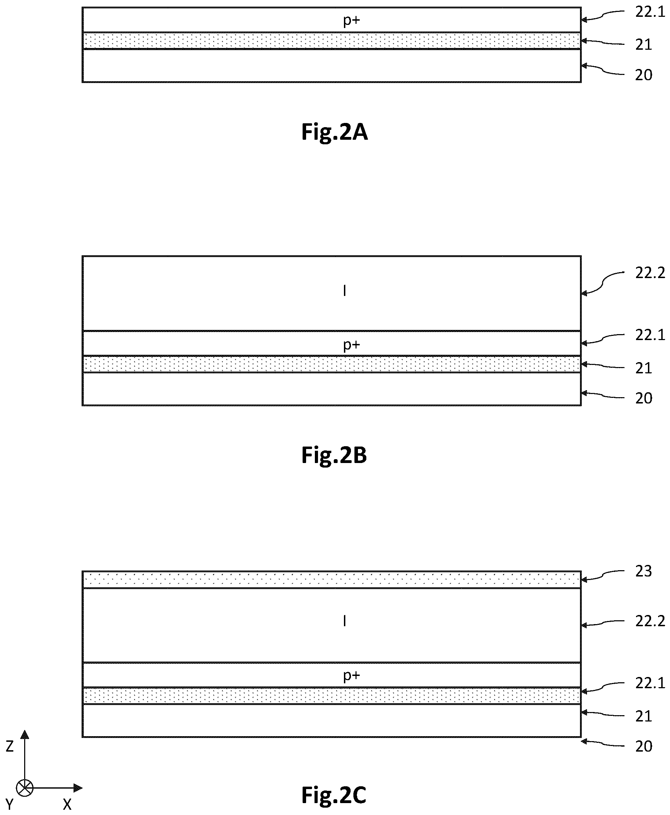

Un exemple de procédé de fabrication d'une matrice de photodiodes selon la variante de réalisation illustrée sur la fig.1A est maintenant décrit en référence aux figures 2A à 2O. Dans cet exemple, les photodiodes 1 sont réalisées en germanium et comportent une jonction PIN, et sont adaptées à détecter un rayonnement infrarouge dans la gamme SWIR. Les photodiodes 1 sont planaires et passivées, et sont polarisées en inverse à partir de la première surface 10a par une puce de commande hybridée à la matrice de photodiode.

En référence à la fig.2A, on réalise une première sous-couche semiconductrice 22.1 de germanium monocristallin. La première sous-couche semiconductrice 22.1 est solidarisée à une couche support 20, ici en silicium, par l'intermédiaire d'une couche isolante inférieure 21, ici en un oxyde de silicium. Cet empilement prend la forme d'un substrat GeOI (pour *Germanium On Insulator*, en anglais). Cet empilement est de préférence réalisé au moyen du procédé décrit dans la publication de Reboud et al. intitulée Structural and optical properties of 200mm germanium-on-insulator (GeOI) substrates for silicon photonics applications, Proc. SPIE 9367, Silicon Photonics X, 936714 (February 27, 2015). Un tel procédé présente l'avantage de réaliser une sous-couche semiconductrice de germanium 22.1 présentant une absence totale ou un faible taux de défauts structuraux tels que les dislocations. Le germanium peut être non intentionnellement dopé ou être dopé, par exemple de type p. La sous-couche semiconductrice 22.1 peut présenter une épaisseur comprise entre 100nm et 500nm environ, par exemple égale à 300nm environ, et peut être recouverte d'une couche de protection (non représentée) en un oxyde de silicium. La couche isolante inférieure 21 (BOX, pour *Buried Oxide*, en anglais) peut présenter une épaisseur comprise entre 50nm et 1µm, par exemple comprise entre 100nm et 500nm, et assure avantageusement une fonction d'antireflet.

On réalise ensuite un dopage de la première sous-couche 22.1 en germanium selon le deuxième type de conductivité, ici de type p, par implantation ionique d'un dopant tel que le bore ou le gallium, lorsque la première sous-couche 22.1 était initialement en germanium intrinsèque. La couche de protection, le cas échéant, a été préalablement retirée par un nettoyage de surface, et la première sous-couche 22.1 de germanium peut être revêtue d'une couche d'oxyde de préimplantation (non représentée) d'une épaisseur de quelques dizaines de nanomètres, par exemple égale à 20nm. La sous-couche 22.1 de germanium présente alors un niveau de dopage compris entre 10¹⁸ et 10²⁰ at/cm³ environ. Un recuit de diffusion du dopant peut ensuite être effectué sous azote, pendant quelques minutes à quelques heures, par exemple 1h, à une température pouvant être comprise entre 600°C et 800°C, par exemple égale à 800°C. Ce recuit peut ne pas être effectué lorsque la sous-couche 22.1 était dopée à la croissance. Une autre manière de fabriquer cette couche p+ est par épitaxie d'une couche de germanium dopé en bore in situ entre 10¹⁸ et 10²⁰ at/cm³ environ sur une sous-couche de germanium intrinsèque. Cette épitaxie peut se faire entre 400 et 800°C mais préférentiellement à 400°C.

En référence à la fig.2B, on réalise une deuxième sous-couche semiconductrice 22.2 de germanium par épitaxie à partir de la première sous-couche 22.1. Les deux sous-couches 22.1, 22.2 sont destinées à former les portions de détection 10 coplanaires en germanium de la matrice de photodiodes 1. La deuxième sous-couche 22.2 est formée par épitaxie, par exemple par dépôt chimique en phase vapeur (CVD, pour *Chemical Vapor Deposition*, en anglais) et de précédence en pression réduite (RPCVD, pour *Reduced Pressure Chemical Vapor Déposition*) ou par toute autre technique d'épitaxie. Des recuits peuvent être effectués pour diminuer le taux de dislocations dans la sous-couche 22.2. La couche d'oxyde de préimplémentation, le cas échéant, a été préalablement retirée par un nettoyage de surface. La deuxième sous-couche 22.2 de germanium est ici intrinsèque, c'est-à-dire non intentionnellement dopée dans la mesure où l'on souhaite réaliser une jonction PIN. Elle est destinée à former la zone d'absorption lumineuse des photodiodes 1. Son épaisseur dépend de la gamme de longueurs d'onde du rayonnement lumineux à détecter dans le cas d'une photodiode 1. Dans le cadre de photodiodes SWIR, la sous-couche 22.2 de germanium intrinsèque présente une épaisseur par exemple comprise entre 0,5µm et 3µm, de préférence égale à 1,5µm.

En référence à la fig.2C, on dépose une couche isolante supérieure 23 de manière à recouvrir continûment la face supérieure de la deuxième sous-couche 22.2, c'est-à-dire de manière à recouvrir les portions de détection 10 des photodiodes 1. La couche isolante supérieure 23 est réalisée en un matériau diélectrique, par exemple un oxyde, un nitrure ou un oxynitrure de silicium. Un nettoyage de la face supérieure de la deuxième sous-couche 22.2 peut avoir été effectué au préalable. La couche isolante supérieure 23 peut présenter une épaisseur comprise entre 10nm et 600nm.

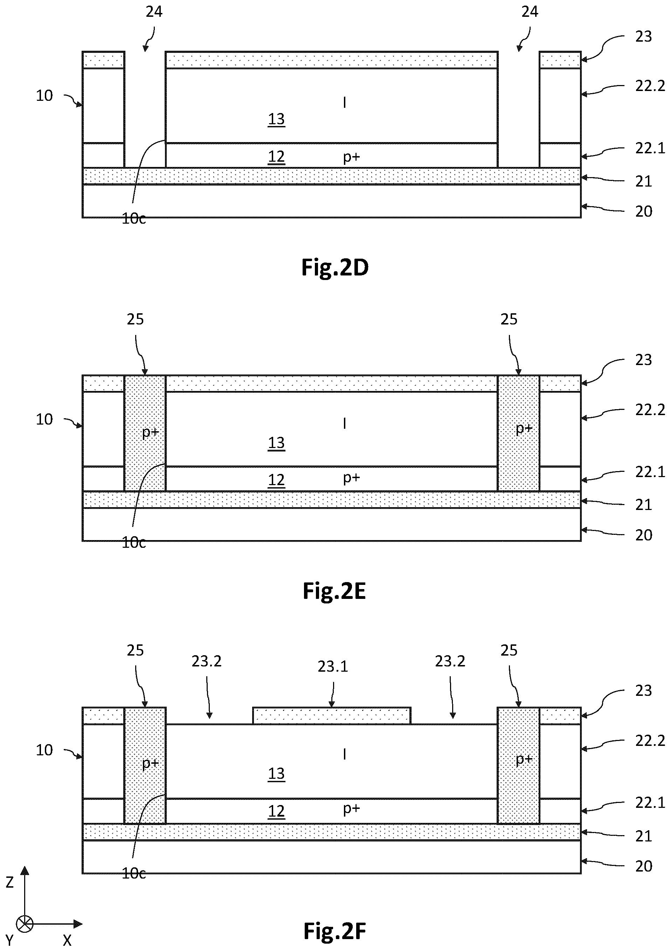

En référence à la fig.2D, on réalise, par photolithographie et gravure, les tranchées 24 destinées à pixelliser les photodiodes 1 et à participer à les polariser électriquement en inverse. On réalise ainsi une gravure localisée de la couche isolante supérieure 23, de la sous-couche 22.2 de germanium intrinsèque, et de la sous-couche 22.1 de germanium dopé p+, jusqu'à déboucher ici sur la face supérieure de la couche isolante inférieure 21 (mais les tranchées 24 peuvent déboucher sur la sous-couche 22.1 sans la traverser). Chaque tranchée 24 s'étend ainsi de préférence continûment autour d'une photodiode 1. On obtient ainsi une pluralité de portions de détection 10 séparées les unes des autres par une tranchée continue 24. Elles sont obtenues de préférence par une technique de gravure anisotrope, de manière à obtenir une bordure latérale 10c sensiblement verticale suivant l'axe Z. Les tranchées 24 présentent une dimension transversale (largeur) dans le plan XY pouvant être comprise entre 300nm et 2µm, par exemple égale à 1µm. Les portions de détection 10 peuvent ainsi présenter une forme dans le plan XY par exemple circulaire, ovale, polygonale, par exemple carrée, ou toute autre forme.

En référence à la fig.2E, on réalise ensuite les portions périphériques semiconductrices 25. Pour cela, on dépose un matériau semiconducteur dopé de manière à remplir les tranchées 24. Le matériau semiconducteur est de préférence un matériau à base de silicium, par exemple du silicium amorphe, du silicium polycristallin, de silicium germanium, voire du germanium amorphe. Le matériau semiconducteur est dopé selon le deuxième type de conductivité, ici de type p au bore ou au gallium, avec une concentration de dopants de l'ordre de 10¹⁹ à 10²⁰ at/cm³ environ. Ainsi, le matériau semiconducteur dopé vient au contact de la bordure latérale 10c par la tranchée 24. Une étape de polissage mécanochimique (CMP) est ensuite effectuée, avec arrêt sur la face supérieure de la couche isolante supérieure 23, pour éliminer le matériau semiconducteur en excès et planariser la face supérieure formée par la couche isolante supérieure 23 et le matériau semiconducteur de la portion périphérique semiconductrice 25. On obtient ainsi une portion périphérique semiconductrice 25 dopée p+ dans chaque tranchée 24.

En référence à la fig.2F, on réalise, par photolithographie et gravure, des ouvertures périphériques 23.2 dans la couche isolante supérieure 23, lesquelles sont traversantes pour déboucher sur la face supérieure de la sous-couche 22.2 intrinsèque. Pour chaque photodiode 1, l'ouverture périphérique 23.2 entoure dans le plan XY une portion centrale 23.1 de la couche isolante supérieure 23 destinée à la réalisation ultérieure de la première région 11 dopée n+. L'ouverture périphérique 23.2 présente une dimension radiale dans le plan XY, à partir de la portion centrale 21.1, qui définira ultérieurement la dimension radiale de la portion périphérique ferroélectrique 26.1. Cette dimension radiale dépend de la taille de la photodiode 1. Elle peut être comprise entre 100nm et quelques microns. Dans cet exemple, l'ouverture périphérique 23.2 s'étend radialement dans le plan XY jusqu'à déboucher sur la bordure interne de la portion périphérique semiconductrice 25 dopée p, mais en variante elle peut ne pas déboucher sur la portion périphérique semiconductrice 25 dopée p et restée ainsi délimitée dans le plan XY par la couche isolante supérieure 23.

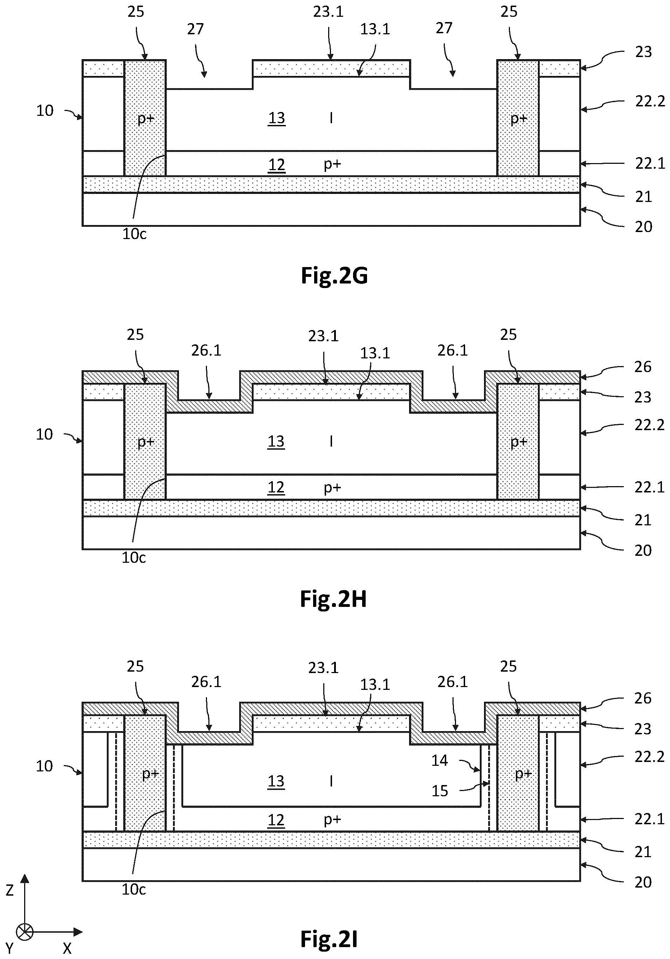

En référence à la fig.2G, on réalise par gravure une échancrure périphérique 27 dans la sous-couche 22.2 du germanium intrinsèque, d'une même dimension radiale que l'ouverture périphérique 23.2, et d'une profondeur qui dépend avantageusement de l'épaisseur souhaitée de la première région 11 dopée n+ (cette profondeur permettra d'éviter une diffusion latérale excessive des dopants, lors de l'étape de réalisation de la première région 11 dopée n+). Cette profondeur peut être comprise entre 50nm et 600nm, par exemple égale à 200nm. On peut ensuite effectuer un nettoyage de surface de la sous-couche 22.2 du germanium intrinsèque. La région intermédiaire 13 présente alors une partie en saillie 13.1 suivant la direction +Z, entourée par l'échancrure périphérique 27 dans le plan XY, et recouverte par la portion centrale 23.1 de la couche isolante supérieure 23.

En référence à la fig.2H, on dépose une couche 26 réalisée en un matériau ferroélectrique, de manière à remplir les échancrures périphériques 27. Cette couche ferroélectrique 26 présente une épaisseur au moins égale à la profondeur des échancrures périphériques 27. Elle recouvre donc continûment la couche isolante supérieure 23 (en particulier la portion centrale 23.1) et la face supérieure de la portion périphérique semiconductrice 25, ainsi que la surface libre de la sous-couche 22.2 du germanium dans les échancrures périphériques 27. La portion périphérique ferroélectrique 26.1 est la partie de la couche 26 qui est située dans l'échancrure périphérique 27, au contact du germanium de la sous-couche 22.2 (donc de la région intermédiaire 13). Elle entoure dans le plan XY la partie en saillie 13.1 de la région intermédiaire 13.

En référence à la fig.2I, on réalise ensuite un recuit de cristallisation du matériau ferroélectrique, par exemple à une température comprise entre 500°C et 750°C pendant 5 à 30min. Ce recuit permet également la formation des régions latérales 14 dopées p+ par diffusion des éléments dopants depuis les portions périphériques semiconductrices 25 dopées p+ vers la région intermédiaire 13. Par ailleurs, de manière simultanée, la zone latérale 15 à ouverture de gap est formée par interdiffusion entre le germanium de la portion de détection 10 et le silicium de la portion périphérique semiconductrice 25.

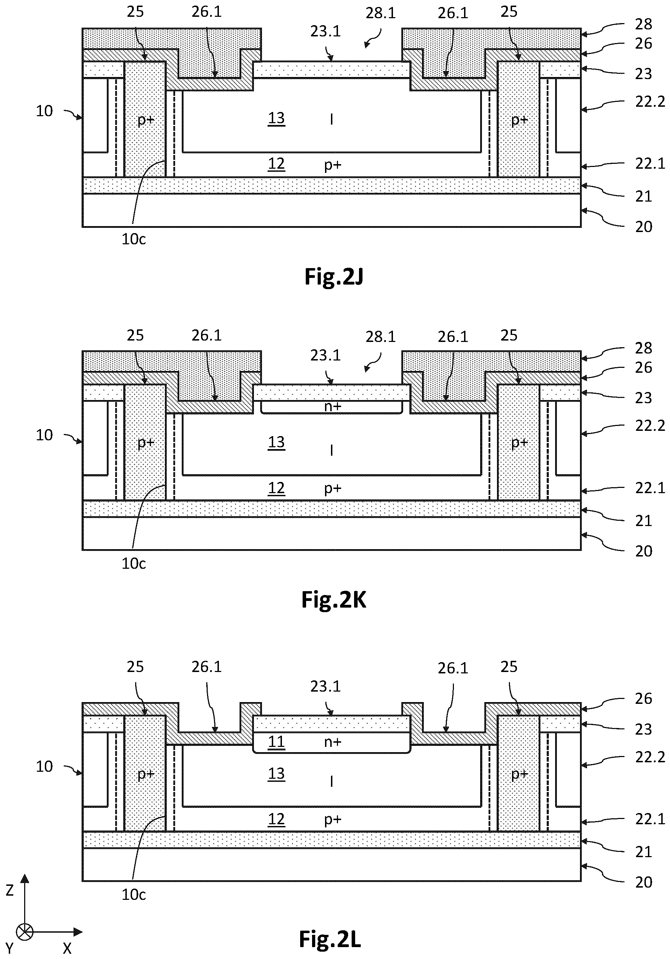

En référence à la fig.2J, on dépose un masque 28 de résine photosensible dans le but de réaliser la première portion 11 dopée n+. Ce masque 28 présente une ouverture 28.1 destinée à l'implantation de dopants de type n dans le germanium de la région intermédiaire 13. On réalise une gravure de la partie de la couche ferroélectrique 26 située au niveau de cette ouverture d'implantation 28.1, de manière à rendre libre une surface de la portion centrale 23.1 de la couche isolante supérieure 23.

En référence à la fig.2K, on réalise une implantation ionique d'éléments dopants de type n, par exemple du phosphore, de l'arsenic ou de l'antimoine (ou une combinaison de ces éléments), dans le germanium intrinsèque de la portion de détection 10, au travers de l'ouverture d'implantation 28.1. La concentration des éléments dopants peut être comprise entre 10¹⁹ et 10²¹ at/cm³.

En référence à la fig.2L, on réalise un recuit de diffusion et d'activation des éléments dopants ayant été implantés, à une température par exemple comprise entre 550°C et 700°C pendant une durée de 5s à 30s. Dans le cas où la profondeur d'implantation des éléments dopants est inférieure à l'épaisseur de la couche ferroélectrique 26, celle-ci permet alors de bloquer la diffusion latérale des éléments dopants en direction de la portion périphérique semiconductrice 25 dopée p+. Quoi qu'il en soit, on obtient une première région 11 dopée n+ ayant les dimensions latérales souhaitées, et on limite les risques d'un court-circuit entre cette première région 11 dopée n+ et la portion périphérique semiconductrice 25 dopée p+. On supprime également la couche 28 de résine photosensible.

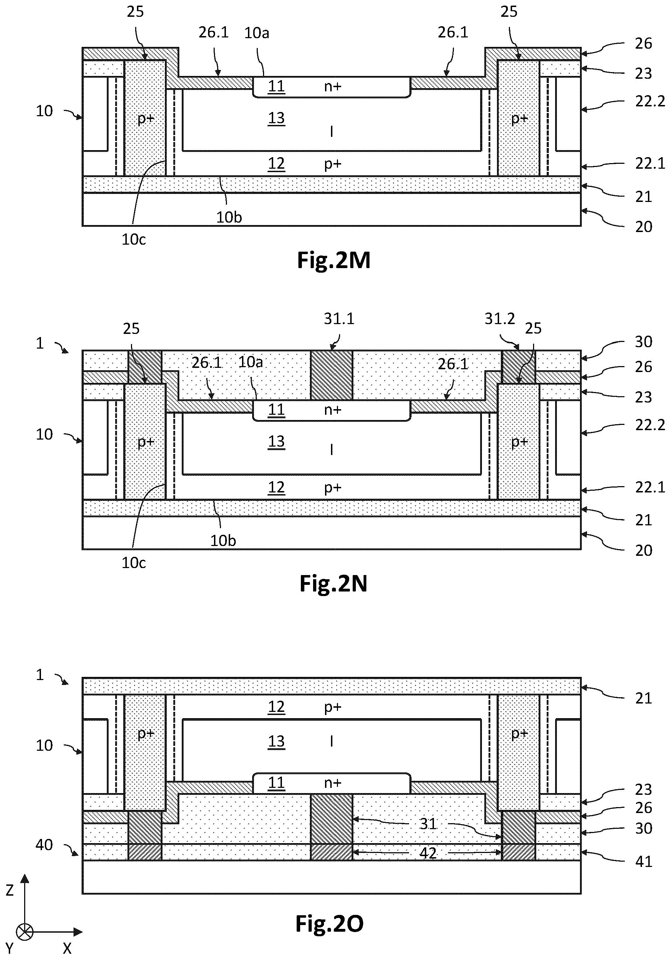

En référence à la fig.2M, on réalise le retrait de la portion centrale 23.1 de la couche isolante supérieure 23, de manière à rendre libre la face supérieure de la portion de détection 10, correspondant ici à celle de la première région 11 dopée n+. Les parties de la couche ferroélectrique 26 qui étaient au contact de la portion centrale sont également retirées. On peut ensuite réaliser un nettoyage de la surface supérieure de la première région 11 dopée n+. Il en résulte que la face supérieure de la portion périphérique ferroélectrique 26.1 et la face supérieure de la première région 11 dopée n+ sont ici coplanaires. Elles définissent ensemble la première surface 10a, qui est opposée à la deuxième surface 10b.

En référence à la fig.2N, on dépose la couche diélectrique 30 de manière à recouvrir l'empilement optoélectronique ainsi réalisé du côté de la première surface 10a. Cette couche diélectrique 30 s'étend ainsi sur et au contact de la couche ferroélectrique 26 et de la première région 11 dopée n+. Elle est réalisée en un matériau diélectrique, par exemple un oxyde, nitrure ou oxynitrure de silicium, un oxyde ou nitrure d'aluminium, un oxyde d'hafnium, entre autres. Elle peut présenter une épaisseur par exemple comprise entre 10nm et 600nm.

On réalise ensuite des métallisations de contact 31, s'étendant au travers de la couche diélectrique 30, et venant au contact de la première région 11 dopée n+ (pour la métallisation centrale 31.1) et au contact de la portion périphérique semiconductrice 25 dopée p+ (pour la métallisation latérale 31.2). Les métallisations de contact 31 peuvent être réalisées de manière classique, par remplissage des ouvertures traversant la couche diélectrique 30 d'au moins un matériau métallique (couche barrière à base de Ti, coeur en cuivre), suivi d'une étape de planarisation CMP. La couche diélectrique 30 et les métallisations de contact 31 présentent ensemble une même face supérieure coplanaire.

En référence à la fig.2O, on réalise l'hybridation de l'empilement optoélectronique ainsi obtenu sur une puce de commande 40. La face de connexion de la puce de commande 40 peut ainsi être revêtue d'une couche isolante 41, réalisée en un matériau diélectrique, traversée par des métallisations 42. L'empilement optoélectronique et la puce de commande 40 sont ainsi assemblés par adhésion moléculaire hybride, par contact des faces formées des métallisations de contact 31, 42 et des couches isolantes 30, 41. Un recuit de collage peut être effectué de manière à augmenter l'énergie de collage surfacique entre les deux faces en contact. On effectue ensuite la suppression de la couche support 20, par exemple par abrasion (*grinding*, en anglais), de manière à exposer la couche isolante inférieure 21. Celle-ci forme ainsi la face de réception du rayonnement lumineux à détecter, et assure avantageusement une fonction d'antireflet.

Le procédé de fabrication permet ainsi d'obtenir une ou plusieurs photodiodes 1 passivées, comportant chacune une portion périphérique ferroélectrique 26.1 entourant la première région 11 dopée n+ dans le plan XY, et située entre et au contact de la couche diélectrique 30 et de la région intermédiaire 13. La présence d'une telle portion périphérique ferroélectrique 26.1, lorsque la photodiode 1 est polarisée, permet d'orienter les dipôles ferroélectriques horizontalement, ce qui permet de réduire la composante surfacique du courant d'obscurité, et donc améliorer les performances de la photodiode 1.

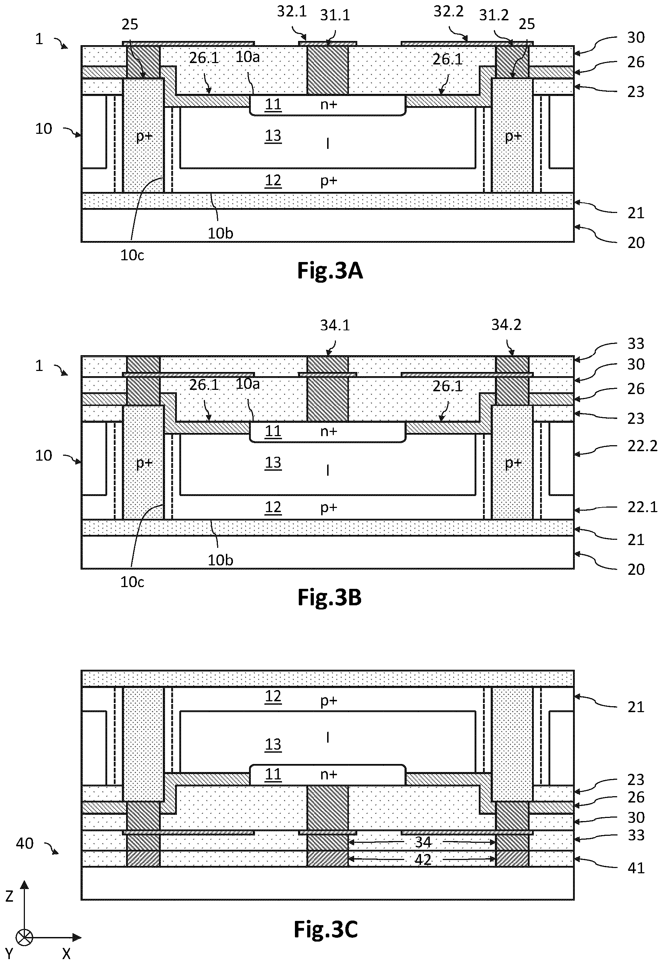

Les figures 3A à 3C illustrent certaines étapes d'un procédé de fabrication d'une photodiode similaire à celle illustrée sur la fig.1B. Dans ce cas, la photodiode 1 comporte des électrodes planaires permettant d'orienter les dipôles ferroélectriques suivant une direction verticale. On considère ici l'empilement optoélectronique obtenu lors de l'étape 2N.

En référence à la fig.3A, on réalise des électrodes planaires 32 venant au contact des métallisations 31, par exemple à base de Ti/TiN, et présentant une épaisseur de l'ordre de 10 à 40nm environ. Ainsi, on réalise une électrode périphérique 32.2 venant au contact de la métallisation périphérique 31.2 et s'étendant dans le plan XY sur la couche diélectrique 30 de manière à être en regard (à la verticale) de la portion périphérique ferroélectrique 26.1 et ici d'une partie de la première région 11 dopée n+. On réalise également une électrode centrale 32.1 venant au contact de la métallisation centrale 31.1.

En référence à la fig.3B, on dépose une deuxième couche isolante supérieure 33, de manière à recouvrir la couche diélectrique 30 et les électrodes planaires 32.1 et 32.2. Des deuxièmes métallisations de contact 34.1, 34.2 sont réalisées au travers de la couche isolante 33.

En référence à la fig.3C, on réalise l'hybridation de l'empilement optoélectronique ainsi obtenu sur la puce de commande 40. L'empilement optoélectronique et la puce de commande 40 sont ici assemblés par adhésion moléculaire hybride, par contact des faces formées des métallisations de contact 34, 42 et des couches isolantes 33, 41. On effectue ensuite la suppression de la couche support 20, par exemple par abrasion (*grinding*, en anglais), de manière à exposer la couche isolante inférieure 21.

Le procédé de fabrication permet ainsi d'obtenir une ou plusieurs photodiodes 1 passivées, comportant chacune une portion périphérique ferroélectrique 26.1 entourant la première région 11 dopée n+ et située au niveau de la première surface 10a, donc au contact de la couche diélectrique 30. La présence d'une telle portion périphérique ferroélectrique 26.1, lorsque la photodiode 1 est polarisée, du fait de l'électrode planaire 32.2 permet d'orienter les dipôles ferroélectriques verticalement, ce qui permet de réduire la composante surfacique du courant d'obscurité, et donc améliorer les performances de la photodiode 1.

Des modes de réalisation particuliers viennent d'être décrits. Différentes variantes et modifications apparaîtront à l'homme du métier.

## Revendications

1. Photodiode (1), présentant une première surface (10a) et une deuxième surface (10b) opposées l'une à l'autre et parallèles à un plan principal, comportant :
o une portion de détection (10), réalisée en un matériau semiconducteur, comportant :
• une première région (11) dopée selon un premier type de conductivité et affleurant la première surface (10a), et destinée à être polarisée électriquement ;
• une deuxième région (12) dopée selon un deuxième type de conductivité opposé au premier type, et affleurant la deuxième surface (10b) ;
• une région intermédiaire (13), située entre la première région (11) et la deuxième région (12) ;
o une couche diélectrique (30), recouvrant la portion de détection (10) sur la première surface (10a) en venant au contact de la première région (11) ;
o une portion périphérique semiconductrice (25), réalisée en un matériau semiconducteur dopé selon le deuxième type de conductivité, destinée à être polarisée électriquement, et entourant la portion de détection (10) dans le plan principal et venant au contact de la deuxième région (12) ;
o **caractérisée en ce qu'**elle comporte :
o une portion périphérique ferroélectrique (26.1), réalisée en un matériau ferroélectrique,
• située entre et au contact de la région intermédiaire (13) et de la couche diélectrique (30), et
• située entre la première région (11) et la portion périphérique semiconductrice (25) et entourant la première région (11) dans le plan principal.

2. Photodiode (1) selon la revendication 1, dans laquelle la portion périphérique ferroélectrique (26.1) est latéralement au contact de la première région (11) d'une part, et de la portion périphérique semiconductrice (25) d'autre part.

3. Photodiode (1) selon la revendication 1 ou 2, dans laquelle la portion de détection (10) présente une échancrure périphérique (27) délimitant une partie en saillie (13.1) entourée par la portion périphérique ferroélectrique (26.1) dans le plan principal.

4. Photodiode (1) selon l'une quelconque des revendications 1 à 3, dans laquelle la portion de détection (10) est réalisée à base de germanium, et la portion périphérique semiconductrice (25) est réalisée à base de silicium.

5. Photodiode (1) selon l'une quelconque des revendications 1 à 4, dans laquelle la portion périphérique ferroélectrique (26.1) est réalisée à base d'un matériau choisi parmi le PZT, le PLZT, le BT, le PT, le PLT, le PVDF, ainsi que parmi le HfO₂, le ZnO, et le AlN.

6. Photodiode (1) selon l'une quelconque des revendications 1 à 5, dans laquelle la couche diélectrique (30) est traversée par une métallisation centrale (31.1) venant contacter la première région (11), et par une métallisation latérale (31.2) venant contacter la portion périphérique semiconductrice (25).

7. Photodiode (1) selon la revendication 6, comportant une électrode périphérique (32.2) s'étendant sur la couche diélectrique (30) et au contact de la métallisation latérale (31.2), entourant la première région (11), et située à la verticale de la portion périphérique ferroélectrique (26.1).

8. Matrice de photodiodes (1), comportant une pluralité de photodiodes (1) selon l'une quelconque des revendications 1 à 7, dans laquelle des faces supérieures des premières régions (11), opposées aux deuxièmes régions (12), sont coplanaires, et les deuxièmes surfaces (10b) sont coplanaires.

9. Dispositif optoélectronique comportant une matrice de photodiodes (1) selon la revendication 8 et une puce de commande hybridée à la matrice de photodiodes, adaptée à polariser en inverse les photodiodes.

10. Procédé de fabrication d'une photodiode (1) selon l'une quelconque des revendications 1 à 7, comportant les étapes suivantes :
o réalisation d'un empilement comportant une première sous-couche (22.1) dopée sur le deuxième type de conductivité et destinée à former la deuxième région (12), recouverte d'une deuxième sous-couche (22.2) destinée à former la région intermédiaire (13) ;
o dépôt d'une couche isolante supérieure (23) sur la deuxième sous-couche (22.2) ;
o réalisation de la portion périphérique semiconductrice (25) s'étendant au travers de la couche isolante supérieure (23) et de la deuxième sous-couche (22.2), jusqu'à déboucher sur la première sous-couche (22.1) ;
o réalisation d'une échancrure périphérique (27) dans la deuxième sous-couche (22.2), au travers d'une ouverture périphérique (23.2) entourant une portion centrale (23.1) de la couche isolante supérieure (23) ;
o réalisation de la portion périphérique ferroélectrique (26.1) remplissant l'échancrure périphérique (27) ;
o suppression de la portion centrale (23.1) ;
o réalisation de la première région (11) dans la deuxième sous-couche (22.2) ;
o dépôt de la couche diélectrique (30) sur et au contact de la portion périphérique ferroélectrique (26.1) et de la première région (11).

11. Procédé de fabrication selon la revendication 10, comportant une étape de recuit de cristallisation du matériau de la portion périphérique ferroélectrique (26.1), assurant en outre une diffusion des éléments dopants depuis la portion périphérique semiconductrice (25) dans la portion de diffusion (10), formant ainsi dans la portion de détection (10) une région latérale (14) dopée selon le deuxième type de conductivité.

12. Procédé de fabrication selon la revendication 11, la portion de détection (10) étant réalisée à base de germanium et portion périphérique semiconductrice (25) étant réalisée à base de silicium, dans lequel le recuit de cristallisation assure en outre une diffusion du silicium de la portion périphérique semiconductrice (25) vers la portion de détection (10), formant ainsi une zone latérale (15) réalisée à base de silicium germanium.

13. Procédé de fabrication selon l'une quelconque des revendications 10 à 12, dans lequel l'étape de réalisation de la première région (11) comporte l'implantation d'éléments dopants dans la deuxième sous-couche (22.2) au travers de la portion centrale (23.1).

14. Procédé de fabrication selon la revendication 13, dans lequel la profondeur d'implantation est inférieure à l'épaisseur de la portion périphérique ferroélectrique (26.1) étant au contact, latéralement, d'une partie en saillie (13.1) de la deuxième sous-couche (22.2) délimitée par l'échancrure périphérique (27), et comportant un recuit d'activation des éléments dopants, la portion périphérique ferroélectrique (26.1) assurant un blocage latéral de la diffusion desdits éléments dopants lors de ce recuit.

## Patentansprüche

1. Fotodiode (1), die eine erste Oberfläche (10a) und eine zweite Oberfläche (10b) aufweist, die einander gegenüberliegen und zu einer Hauptebene parallel sind, umfassend:
o einen Detektionsabschnitt (10), der aus einem Halbleitermaterial hergestellt ist, umfassend:
• eine erste Region (11), die gemäß einem ersten Leitfähigkeitstyp dotiert ist und an die erste Oberfläche (10a) angrenzt und dazu bestimmt ist, elektrisch polarisiert zu werden;
• eine zweite Region (12), die gemäß einem zweiten Leitfähigkeitstyp, der zu dem ersten Typ entgegengesetzt ist, dotiert ist und an die zweite Oberfläche (10b) angrenzt;
• eine Zwischenregion (13), die sich zwischen der ersten Region (11) und der zweiten Region (12) befindet;
o eine dielektrische Schicht (30), die den Detektionsabschnitt (10) auf der ersten Oberfläche (10a) abdeckt und mit der ersten Region (11) in Kontakt kommt;
o einen Halbleiterumfangsabschnitt (25), der aus einem gemäß dem zweiten Leitfähigkeitstyp dotierten Halbleitermaterial hergestellt ist und dazu bestimmt ist, elektrisch polarisiert zu werden, und der den Detektionsabschnitt (10) in der Hauptebene umgibt und mit der zweiten Region (12) in Kontakt kommt;
o **dadurch gekennzeichnet, dass** sie Folgendes umfasst:
o einen ferroelektrischen Umfangsabschnitt (26.1), der aus einem ferroelektrischen Material hergestellt ist,
• der sich zwischen der Zwischenregion (13) und der dielektrischen Schicht (30) befindet und mit diesen in Kontakt ist und
• der sich zwischen der ersten Region (11) und dem Halbleiterumfangsabschnitt (25) befindet und die erste Region (11) in der Hauptebene umgibt.

2. Fotodiode (1) nach Anspruch 1, wobei der ferroelektrische Umfangsabschnitt (26.1) einerseits mit der ersten Region (11) und andererseits mit dem Halbleiterumfangsabschnitt (25) seitlich in Kontakt ist.

3. Fotodiode (1) nach Anspruch 1 oder 2, wobei der Detektionsabschnitt (10) eine Umfangsaussparung (27) aufweist, die einen Vorsprung (13.1) begrenzt, der in der Hauptebene von dem ferroelektrischen Umfangsabschnitt (26.1) umgeben ist.

4. Fotodiode (1) nach einem beliebigen der Ansprüche 1 bis 3, wobei der Detektionsabschnitt (10) auf Basis von Germanium hergestellt ist und der Halbleiterumfangsabschnitt (25) auf Basis von Silizium hergestellt ist.

5. Fotodiode (1) nach einem beliebigen der Ansprüche 1 bis 4, wobei der ferroelektrische Umfangsabschnitt (26.1) auf Basis eines Materials hergestellt ist, das aus PZT, PLZT, BT, PT, PLT, PVDF sowie aus HfO₂, ZnO und AIN ausgewählt ist.

6. Fotodiode (1) nach einem beliebigen der Ansprüche 1 bis 5, wobei die dielektrische Schicht (30) von einer mittigen Metallisierung (31.1), die die erste Region (11) kontaktiert, und von einer seitlichen Metallisierung (31.2), die den Halbleiterumfangsabschnitt (25) kontaktiert, durchquert wird.

7. Fotodiode (1) nach Anspruch 6, die eine Umfangselektrode (32.2) umfasst, die sich auf der dielektrischen Schicht (30) und in Kontakt mit der seitlichen Metallisierung (31.2) erstreckt, die erste Region (11) umgibt und sich senkrecht zu dem ferroelektrischen Umfangsabschnitt (26.1) befindet.

8. Fotodiodenmatrix (1), die eine Vielzahl von Fotodioden (1) nach einem beliebigen der Ansprüche 1 bis 7 umfasst, wobei obere Flächen der ersten Regionen (11), die zu den zweiten Regionen (12) entgegengesetzt sind, koplanar sind und die zweiten Oberflächen (10b) koplanar sind.

9. Optoelektronische Vorrichtung, die eine Fotodiodenmatrix (1) nach Anspruch 8 und einen Steuerchip umfasst, der an die Fotodiodenmatrix hybridisiert ist und dazu angepasst ist, die Fotodioden umgekehrt zu polarisieren.

10. Verfahren zur Fertigung einer Fotodiode (1) nach einem beliebigen der Ansprüche 1 bis 7, das die folgenden Schritte umfasst:
o Herstellen eines Stapels, der eine erste Unterschicht (22.1) umfasst, die auf den zweiten Leitfähigkeitstyp dotiert ist und dazu bestimmt ist, die zweite Region (12) zu bilden, und die von einer zweiten Unterschicht (22.2) abgedeckt wird, die dazu bestimmt ist, die Zwischenregion (13) zu bilden;
o Abscheiden einer oberen Isolierschicht (23) auf die zweite Unterschicht (22.2);
o Herstellen des Halbleiterumfangsabschnitts (25), der sich durch die obere Isolierschicht (23) und die zweite Unterschicht (22.2) erstreckt, bis er an der ersten Unterschicht (22.1) mündet;
o Herstellen einer Umfangsaussparung (27) in der zweiten Unterschicht (22.2) durch eine Umfangsöffnung (23.2) hindurch, die einen mittigen Abschnitt (23.1) der oberen Isolierschicht (23) umgibt;
o Herstellen des ferroelektrischen Umfangsabschnitts (26.1), der die Umfangsaussparung (27) ausfüllt;
o Entfernen des mittigen Abschnitts (23.1);
o Herstellen der ersten Region (11) in der zweiten Unterschicht (22.2);
o Abscheiden der dielektrischen Schicht (30) auf den ferroelektrischen Umfangsabschnitt (26.1) und die erste Region (11) und diese kontaktierend.

11. Fertigungsverfahren nach Anspruch 10, das einen Schritt des Rekristallisationsglühens des Materials des ferroelektrischen Umfangsabschnitts (26.1) umfasst, was ferner ein Diffundieren der Dotierungselemente von dem Halbleiterumfangsabschnitt (25) in den Diffusionsabschnitt (10) sicherstellt, sodass in dem Detektionsabschnitt (10) eine seitliche Region (14) gebildet wird, die gemäß dem zweiten Leitfähigkeitstyp dotiert ist.

12. Fertigungsverfahren nach Anspruch 11, wobei der Detektionsabschnitt (10) auf Basis von Germanium hergestellt ist und der Halbleiterumfangsabschnitt (25) auf Basis von Silizium hergestellt ist, wobei das Rekristallisationsglühen ferner ein Diffundieren des Siliziums des Halbleiterumfangsabschnitts (25) in den Detektionsabschnitt (10) sicherstellt, sodass ein seitlicher Bereich (15), der auf Basis von Silizium-Germanium hergestellt ist, gebildet wird.

13. Fertigungsverfahren nach einem beliebigen der Ansprüche 10 bis 12, wobei der Schritt des Herstellens der ersten Region (11) das Implantieren von Dotierungselementen in die zweite Unterschicht (22.2) durch den mittigen Abschnitt (23.1) hindurch umfasst.

14. Fertigungsverfahren nach Anspruch 13, wobei die Implantierungstiefe geringer als die Dicke des ferroelektrischen Umfangsabschnitts (26.1) ist, der seitlich mit einem Vorsprung (13.1) der zweiten Unterschicht (22.2), der durch die Umfangsaussparung (27) begrenzt wird, in Kontakt ist, und umfassend ein Aktivierungsglühen der Dotierungselemente, wobei der ferroelektrische Umfangsabschnitt (26.1) während dieses Glühens eine seitliche Sperre für das Diffundieren der Dotierungselemente sicherstellt.

## Claims

1. Photodiode (1), having a first surface (10a) and a second surface (10b) that are opposite one another and parallel to a main plane, comprising:
o a detection portion (10), made of a semiconductor material, comprising:
• a first region (11) doped with a first conductivity type and flush with the first surface (10a), and intended to be electrically biased;
• a second region (12) doped with a second conductivity type opposite the first type, and flush with the second surface (10b);
• an intermediate region (13), located between the first region (11) and the second region (12);
o a dielectric layer (30), covering the detection portion (10) on the first surface (10a) while coming into contact with the first region (11);
o a semiconductor peripheral portion (25), made of a semiconductor material doped with the second conductivity type, intended to be electrically biased, and surrounding the detection portion (10) in the main plane and coming into contact with the second region (12);
o **characterized in that** it comprises:
o a ferroelectric peripheral portion (26.1), made of a ferroelectric material,
• located between and in contact with the intermediate region (13) and the dielectric layer (30), and
• located between the first region (11) and the semiconductor peripheral portion (25) and surrounding the first region (11) in the main plane.

2. Photodiode (1) according to Claim 1, wherein the ferroelectric peripheral portion (26.1) is laterally in contact with the first region (11), on the one hand, and with the semiconductor peripheral portion (25), on the other hand.

3. Photodiode (1) according to Claim 1 or 2, wherein the detection portion (10) has a peripheral indentation (27) delimiting a projecting part (13.1) surrounded by the ferroelectric peripheral portion (26.1) in the main plane.

4. Photodiode (1) according to any one of Claims 1 to 3, wherein the detection portion (10) is formed based on germanium, and the semiconductor peripheral portion (25) is formed based on silicon.

5. Photodiode (1) according to any one of Claims 1 to 4, wherein the ferroelectric peripheral portion (26.1) is formed based on a material chosen from among PZT, PLZT, BT, PT, PLT, PDVF, and also from among HfO₂, ZnO and AIN.

6. Photodiode (1) according to any one of Claims 1 to 5, wherein the dielectric layer (30) is passed through by a central metallization (31.1) that comes into contact with the first region (11), and by a lateral metallization (31.2) that comes into contact with the semiconductor peripheral portion (25).

7. Photodiode (1) according to Claim 6, comprising a peripheral electrode (32.2) extending over the dielectric layer (30) and in contact with the lateral metallization (31.2), surrounding the first region (11), and located vertical to the ferroelectric peripheral portion (26.1).

8. Matrix-array of photodiodes (1), comprising a plurality of photodiodes (1) according to any one of Claims 1 to 7, wherein upper faces of the first regions (11), opposite the second regions (12), are coplanar, and the second surfaces (10b) are coplanar.

9. Optoelectronic device comprising a matrix-array of photodiodes (1) according to Claim 8 and a control chip hybridized with the matrix-array of photodiodes, designed to reverse-bias the photodiodes.

10. Process for fabricating a photodiode (1) according to any one of Claims 1 to 7, comprising the following steps:
o producing a stack comprising a first sublayer (22.1) doped with the second conductivity type and intended to form the second region (12), covered by a second sublayer (22.2) intended to form the intermediate region (13);
o depositing an upper insulating layer (23) on the second sublayer (22.2);
o producing the semiconductor peripheral portion (25) extending through the upper insulating layer (23) and through the second sublayer (22.2), until opening out on the first sublayer (22.1);
o producing a peripheral indentation (27) in the second sublayer (22.2), through a peripheral opening (23.2) surrounding a central portion (23.1) of the upper insulating layer (23);
o producing the ferroelectric peripheral portion (26.1) filling the peripheral indentation (27);
o removing the central portion (23.1);
o producing the first region (11) in the second sublayer (22.2);
o depositing the dielectric layer (30) on and in contact with the ferroelectric peripheral portion (26.1) and with the first region (11).

11. Fabrication process according to Claim 10, comprising a step of crystallization-annealing the material of the ferroelectric peripheral portion (26.1), furthermore ensuring diffusion of dopant elements from the semiconductor peripheral portion (25) into the diffusion portion (10), thus forming a lateral region (14) doped with the second conductivity type in the detection portion (10).

12. Fabrication process according to Claim 11, the detection portion (10) being formed based on germanium and the semiconductor peripheral portion (25) being formed based on silicon, wherein the crystallization annealing furthermore ensures diffusion of silicon from the semiconductor central portion (25) to the detection portion (10), thus forming a lateral area (15) formed based on silicon-germanium.

13. Fabrication process according to any one of Claims 10 to 12, wherein the step of producing the first region (11) comprises implanting dopant elements in the second sublayer (22.2) through the central portion (23.1).

14. Fabrication process according to Claim 13, wherein the implantation depth is less than the thickness of the ferroelectric peripheral portion (26.1) that is in contact, laterally, with a projecting part (13.1) projecting from the second sublayer (22.2) delimited by the peripheral indentation (27), and comprising activation-annealing the dopant elements, the ferroelectric peripheral portion (26.1) laterally blocking the diffusion of said dopant elements during this annealing.
